(19) Europäisches Patentamt
European Patent Office
Office européen des brevets

(11) EP 4 307 873 A1

(12) DEMANDE DE BREVET EUROPEEN

(43) Date de publication:
17.01.2024 Bulletin 2024/03

(21) Numéro de dépôt: 23184094.3

(22) Date de dépôt: 07.07.2023

(51) Classification Internationale des Brevets (IPC):
*H10N 70/00* (2023.01)        *H01L 33/00* (2010.01)
*H01L 25/07* (2006.01)

(52) Classification Coopérative des Brevets (CPC):
**H10N 70/00; H01L 25/0756; H01L 33/32;**
H01L 33/0012; H01L 33/24; H01L 33/26;
H01L 33/42

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**KH MA MD TN**

(30) Priorité: **12.07.2022 FR 2207169**

(71) Demandeur: **Commissariat à l'énergie atomique
et aux énergies alternatives**
**75015 Paris (FR)**

(72) Inventeur: **AZRAK, Edy**
**38054 Grenoble cedex 09 (FR)**

(74) Mandataire: **INNOV-GROUP**
**310, avenue Berthelot**
**69372 Lyon Cedex 08 (FR)**

(54) **DISPOSITIF OPTOELECTRONIQUE**

(57) Ce dispositif optoélectronique, comporte :
- un substrat (1),
- au moins une couche active (2), formée sur le substrat (1), et réalisée dans un matériau ;
- des défauts, présents dans le matériau, et possédant une structure énergétique définissant :
un état fondamental dans la bande de valence, comprenant des premier et deuxième états de spin,
un état métastable dans la bande d'énergie interdite,
un état excité dans la bande de conduction ;

- des moyens d'excitation de la couche active (2), configurés pour :
faire transiter des électrons vers l'état excité, puis se relaxant vers le deuxième état de spin par l'intermédiaire de l'état métastable, de sorte que la couche active peut émettre des photons faisant transiter des électrons du deuxième état de spin vers le premier état de spin ; ou faire transiter des électrons du deuxième état de spin vers l'état excité de sorte que la couche active (2) peut détecter des photons faisant transiter des électrons du premier état de spin vers le deuxième état de spin par absorption.

FIG. 1

EP 4 307 873 A1

## Description

### Domaine technique

L'invention se rapporte au domaine technique des dispositifs optoélectroniques.

L'invention trouve notamment son application dans l'émission et la détection dans la gamme de fréquences des micro-ondes. De nombreuses applications sont envisageables, par exemple dans les domaines suivants :

- communications (satellites, engins spatiaux etc.) ;
- réseaux sans fil et radio (Internet, radio en direct etc.) ;
- domestique (fours à micro-ondes etc.) ;
- radars ;
- le médical (traitements des muscles, des cancers etc.) ;
- astronomie (science spatiale etc.) ;
- physique (accélérateurs de particules, spectroscopie, dépôts de couches minces).

### État de l'art

Il existe des sources d'émission de micro-ondes, telles qu'un magnétron, un klystron, un oscillateur Gunn etc.

Ces sources d'émission ne sont pas entièrement satisfaisantes. En effet, un magnétron et un klystron nécessitent des tensions d'accélération des électrons extrêmement élevées (e.g. 230 000 V). Un oscillateur Gunn requiert une énergie moins importante pour produire un rayonnement micro-ondes. En revanche, comme le magnétron et le klystron, un oscillateur Gunn possède une taille importante en raison de la complexité des cavités.

### Exposé de l'invention

L'invention vise à remédier en tout ou partie aux inconvénients précités. A cet effet, l'invention a pour objet un dispositif optoélectronique, comportant :

- un substrat,
- au moins une couche active, formée sur le substrat, et réalisée dans un matériau possédant une bande de valence et une bande de conduction séparées par une bande d'énergie interdite ;
- des défauts, présents dans le matériau, et possédant une structure énergétique définissant :

   un état fondamental dans la bande de valence, comprenant des premier et deuxième états de spin, la transition du deuxième état de spin vers le premier état de spin étant destinée à être radiative,
   un état métastable dans la bande d'énergie interdite,
un état excité dans la bande de conduction ;

- des moyens d'excitation de la couche active, configurés pour :

   faire transiter des électrons vers l'état excité, puis se relaxant vers le deuxième état de spin par l'intermédiaire de l'état métastable, de sorte que la couche active peut émettre des photons faisant transiter des électrons du deuxième état de spin vers le premier état de spin ; ou
   faire transiter des électrons du deuxième état de spin vers l'état excité de sorte que la couche active peut détecter des photons faisant transiter des électrons du premier état de spin vers le deuxième état de spin par absorption.

Ainsi, un tel dispositif selon l'invention permet de résoudre les problèmes de compacité des sources de l'état de la technique grâce à une intégration monolithique de la couche active (couche mince, nanofilaments etc.) avec le substrat. Les électrodes et tout ou partie des moyens d'excitation de la couche active peuvent également être intégrés de manière monolithique avec le substrat afin de former un circuit intégré. Un tel dispositif est donc compatible avec les techniques de la microélectronique, les plateformes silicium ou encore la technologie CMOS, ce qui est impossible avec les sources de l'état de la technique.

Le principe physique est également totalement différent par rapport à l'état de la technique. Les défauts du matériau de la couche active introduisent au moins deux états de spin dans l'état fondamental qui permettent d'obtenir une transition radiative ou une détection par absorption, selon l'application envisagée pour le dispositif.

Le dispositif selon l'invention peut comporter une ou plusieurs des caractéristiques suivantes.

Selon une caractéristique de l'invention, les moyens d'excitation de la couche active comportent :

- des première et deuxième électrodes, électriquement connectées à la couche active ;
- des moyens d'excitation électrique, agencés pour appliquer une tension de polarisation entre les première et deuxième électrodes, les moyens d'excitation électrique étant configurés pour faire transiter des électrons vers l'état excité, puis se relaxant vers le deuxième état de spin par l'intermédiaire de l'état métastable, lorsque la tension de polarisation est positive.

Ainsi, un avantage procuré par les moyens d'excitation électrique est de faciliter la modulation de l'excitation de la couche active.

Selon une caractéristique de l'invention, les moyens d'excitation de la couche active comportent des moyens d'excitation optique, configurés pour faire transiter des électrons vers l'état excité, puis se relaxant vers le deuxième état de spin par l'intermédiaire de l'état métastable.

Selon une caractéristique de l'invention, les moyens d'excitation optique sont situés sur le même substrat que la couche active. Autrement dit, les moyens d'excitation optique sont situés (i.e. disposés, formés) sur le substrat. En d'autres termes, la couche active et les moyens d'excitation optique partagent le même substrat. Les moyens d'excitation optique de la couche active sont ainsi intégrés de manière monolithique avec le substrat afin de former un circuit intégré.

Selon une caractéristique de l'invention, les moyens d'excitation de la couche active comportent :

- des première et deuxième électrodes, électriquement connectées à la couche active ;
- des moyens d'excitation électrique, agencés pour appliquer une tension de polarisation entre les première et deuxième électrodes, les moyens d'excitation électrique étant configurés pour faire transiter des électrons vers l'état excité, puis se relaxant vers le deuxième état de spin par l'intermédiaire de l'état métastable, lorsque la tension de polarisation est positive ;
- des moyens d'excitation optique, configurés pour faire transiter des électrons vers l'état excité, puis se relaxant vers le deuxième état de spin par l'intermédiaire de l'état métastable.

Ainsi, un avantage procuré est d'augmenter l'intensité du rayonnement émis par le dispositif.

Selon une caractéristique de l'invention, les moyens d'excitation de la couche active comportent :

- des première et deuxième électrodes, électriquement connectées à la couche active ;
- des moyens d'excitation électrique, agencés pour appliquer une tension de polarisation entre les première et deuxième électrodes, les moyens d'excitation électrique étant configurés pour faire transiter des électrons du deuxième état de spin vers l'état excité lorsque la tension de polarisation est négative ;
- des moyens d'excitation optique, configurés pour faire transiter des électrons du deuxième état de spin vers l'état excité.

Ainsi, un avantage procuré est d'augmenter la sensibilité de détection du dispositif.

Selon une caractéristique de l'invention, les moyens d'excitation optique comportent au moins une diode électroluminescente formée sur le substrat.

Ainsi, un avantage procuré est de faciliter l'intégration des moyens d'excitation optique.

Selon une caractéristique de l'invention, les moyens d'excitation optique comportent des première et deuxième diodes électroluminescentes s'étendant de part et d'autre de la couche active.

Ainsi, un avantage procuré est d'augmenter l'intensité du rayonnement émis par le dispositif.

Selon une caractéristique de l'invention, le dispositif comporte un résonateur optique à l'intérieur duquel s'étend la couche active, le résonateur optique étant conçu pour coopérer avec les moyens d'excitation optique de sorte que les moyens d'excitation optique font :

- transiter des électrons vers l'état excité, puis se relaxant vers le deuxième état de spin par l'intermédiaire de l'état métastable ; ou
- transiter des électrons du deuxième état de spin vers l'état excité.

Ainsi, un avantage procuré est d'améliorer le confinement du rayonnement d'excitation au sein du dispositif.

Selon une caractéristique de l'invention, la couche active présente des première et seconde surfaces opposées ; le dispositif comporte :

- une première couche dopée, d'un premier type de conductivité, s'étendant en contact de la première surface de la couche active ;
- une seconde couche dopée, d'un second type de conductivité opposé au premier type de conductivité, s'étendant en contact de la seconde surface de la couche active.

Ainsi, un avantage procuré est de faciliter le transport et la manipulation des porteurs de charges.

Selon une caractéristique de l'invention, le dispositif comporte :

- des première et deuxième électrodes, électriquement connectées à la couche active ;
- une première couche électriquement conductrice, de préférence réalisée dans un oxyde conducteur, s'étendant entre la première électrode et la couche active ;
- une deuxième couche électriquement conductrice, de préférence réalisée dans un oxyde conducteur, s'étendant entre la couche active et la deuxième électrode.

Ainsi, un avantage procuré est de faciliter l'injection des porteurs de charge.

Selon une caractéristique de l'invention :

- la première couche électriquement conductrice s'étend entre la première électrode et la première couche dopée ;
- la deuxième couche électriquement conductrice s'étend entre la seconde couche dopée et la deuxième électrode.

Ainsi, un avantage procuré est de faciliter à la fois l'injection et le transport des porteurs de charge.

Selon une caractéristique de l'invention, la couche active comporte des nanofilaments.

Ainsi, un avantage procuré par le facteur de forme des nanofilaments est d'améliorer le confinement des porteurs de charge, améliorer les capacités d'émission ou de détection, et de réduire la consommation énergétique du dispositif.

Selon une caractéristique de l'invention, le dispositif comporte :

- un ensemble de couches actives ;
- une succession de diodes de type p-i-n formée sur le substrat, chaque diode de type p-i-n possédant une zone intrinsèque formée par une couche active de l'ensemble.

Ainsi, un avantage procuré par une telle pluralité de diodes de types p-i-n est d'augmenter l'intensité du rayonnement émis par le dispositif ou d'augmenter la sensibilité de détection du dispositif.

Selon une caractéristique de l'invention, le dispositif comporte des moyens d'application d'un champ magnétique aux défauts, dans lequel la transition entre les premier et deuxième états de spin est définie en présence du champ magnétique.

Ainsi, un avantage procuré est de pouvoir contrôler la différence énergétique entre les premier et deuxième états de spin par l'effet Zeeman.

Selon une caractéristique de l'invention, le matériau de la couche active possède une bande d'énergie interdite supérieure à 1,5 eV, de préférence supérieure à 2 eV.

Selon une caractéristique de l'invention, le matériau de la couche active comporte au moins un composant choisi parmi le nitrure d'aluminium AlN, le nitrure de gallium GaN, l'arséniure de gallium GaAs, le phosphure de gallium GaP, le nitrure de bore BN, l'oxyde de zinc ZnO, le sulfure de zinc ZnS, le tellurure de magnésium MgTe, le séléniure de magnésium MgSe, le nitrure de silicium $Si_3N_4$, le carbure de silicium SiC, le dioxyde de silicium $SiO_2$, l'alumine $Al_2O_3$, le dioxyde de germanium GeOz, un cristal organique, le diamant C.

Ainsi, un avantage procuré par de tels matériaux est de posséder au moins un état métastable dans leur bande interdite en raison de la présence de défauts (e.g. lacunes et/ou impuretés) qui peuvent également introduire deux états de spin dans l'état fondamental.

Selon une caractéristique de l'invention, les défauts comportent au moins un élément choisi parmi une lacune et une impureté.

Selon une caractéristique de l'invention, le substrat est réalisé dans un matériau choisi parmi le silicium Si, le quartz $SiO_2$, le saphir $Al_2O_3$.

Selon une caractéristique de l'invention, la fréquence de la transition entre les premier et deuxième états de spin de l'état fondamental est comprise entre 10 MHz et 1000 GHz, ou entre 30 MHz et 300 GHz.

*Définitions*

- Par « substrat », on entend un support physique autoporté, réalisé dans un matériau de base à partir duquel peut être formé un dispositif pour tout type d'applications, notamment électronique, mécanique, optique. Un substrat peut être une « tranche » (également dénommée « plaquette », « *wafer* » en langue anglaise) qui se présente généralement sous la forme d'un disque issu d'une découpe dans un lingot d'un matériau cristallin.
- Par « couche », on entend une couche ou une pluralité de sous-couches de même nature. Le terme « couche » peut désigner une couche mince pouvant être formée par une technique de dépôt de la microélectronique, et dont l'épaisseur est généralement inférieure à 5 μm. Le terme « couche » peut également désigner des nanofilaments.
- Par « couche active », on entend la couche conçue pour émettre ou détecter un rayonnement électromagnétique.
- Par « état métastable », on entend un état énergétique intermédiaire (situé entre les bandes de conduction et de valence) dans lequel peut se trouver temporairement une particule (e.g. électron). L'état métastable peut servir à obtenir une inversion de population, les électrons pouvant rester à ce niveau énergétique suffisamment longtemps. Ce niveau énergétique peut cumuler des électrons durant le pompage, puis les électrons peuvent passer collectivement dans la bande de valence.
- Par « couche dopée », on entend une couche comportant des dopants de type n ou des dopants de type p. Par « dopants de type n », on entend des impuretés (espèces), qui introduites dans une matrice d'un matériau semi-conducteur, donnent un électron. Par « dopants de type p », on entend des impuretés (espèces) qui introduites dans une matrice d'un matériau semi-conducteur, acceptent un électron ou donnent un trou.
- Par « oxyde conducteur », on entend un oxyde électriquement conducteur, présentant une conductivité électrique à 300 K supérieure ou égale à $10^2$ S/cm.
- « Par électriquement connectées », on entend que les première et deuxième électrodes sont directement ou indirectement électriquement connectées à la couche active. Plus précisément, les première et deuxième électrodes sont directement électriquement connectées à la couche active lorsque les première et deuxième électrodes sont en contact avec la couche active. Les première et deuxième électrodes sont indirectement électriquement connectées à la couche active lorsque des éléments électriquement conducteurs (e.g. des couches dopées) sont interposés entre les électrodes et la couche active.

## Brève description des dessins

D'autres caractéristiques et avantages apparaîtront dans l'exposé détaillé de différents modes de réalisation de l'invention, l'exposé étant assorti d'exemples et de références aux dessins joints.

Figure 1 est une vue schématique en coupe d'un dispositif selon l'invention, utilisé en émission, et illustrant un premier mode de réalisation comportant des moyens d'excitation électrique de la couche active.

Figure 2 est une vue schématique en coupe d'un dispositif selon l'invention, utilisé en émission, et illustrant un deuxième mode de réalisation comportant des moyens d'excitation électrique de la couche active.

Figure 3 est une vue schématique en coupe d'un dispositif selon l'invention, utilisé en émission, et illustrant un troisième mode de réalisation comportant des moyens d'excitation électrique de la couche active.

Figure 4 est une vue schématique en coupe d'un dispositif selon l'invention, utilisé en émission, et illustrant un quatrième mode de réalisation comportant des moyens d'excitation électrique de la couche active.

Figure 5 est une vue schématique en coupe d'un dispositif selon l'invention, utilisé en émission, et illustrant un cinquième mode de réalisation comportant des moyens d'excitation électrique de la couche active.

Figure 6 est une vue schématique en coupe d'un dispositif selon l'invention, utilisé en émission, et illustrant un premier mode de réalisation comportant des moyens d'excitation optique de la couche active.

Figure 7 est une vue schématique en coupe d'un dispositif selon l'invention, pouvant être utilisé en émission ou en détection, illustrant un premier mode de réalisation comportant des moyens d'excitation électrique et optique de la couche active.

Figure 8 est une vue schématique en coupe d'un dispositif selon l'invention, utilisé en émission ou en détection, et illustrant un deuxième mode de réalisation comportant des moyens d'excitation électrique et optique de la couche active.

Figure 9 est une vue schématique partielle en coupe d'un dispositif selon l'invention, utilisé en émission, et illustrant un premier mode de réalisation comportant une couche active formant un nanofilament, la couche active étant destinée à être excitée électriquement.

Figure 10 est une vue schématique partielle en coupe d'un dispositif selon l'invention, utilisé en émission, et illustrant un deuxième mode de réalisation comportant plusieurs couches actives (multicouche) formant un nanofilament, les couches actives étant destinées à être excitées électriquement.

Figure 11 est un diagramme de Jablonski représentant partiellement la structure énergétique d'un matériau de la couche active présentant des défauts. « ms » désigne le nombre quantique magnétique de spin.

Il est à noter que les dessins décrits ci-avant sont schématiques, et ne sont pas nécessairement à l'échelle par souci de lisibilité et pour en simplifier leur compréhension. Les coupes sont effectuées selon la normale à la surface du substrat recevant les éléments du dispositif selon l'invention.

## Exposé détaillé des modes de réalisation

Les éléments identiques ou assurant la même fonction porteront les mêmes références pour les différents modes de réalisation, par souci de simplification.

Un objet de l'invention est un dispositif optoélectronique, comportant :

- un substrat 1,
- au moins une couche active 2, formée sur le substrat 1, et réalisée dans un matériau possédant une bande de valence BV et une bande de conduction BC séparées par une bande d'énergie interdite $Eg$ ;
- des défauts, présents dans le matériau, et possédant une structure énergétique définissant :

    un état fondamental GS dans la bande de valence BV, comprenant des premier et deuxième états de spin $S_1$, $S_2$, la transition T du deuxième état de spin $S_2$ vers le premier état de spin $S_1$ étant destinée à être radiative,
    un état métastable MS dans la bande d'énergie interdite $Eg$,
    un état excité dans la bande de conduction BC ;

- des moyens d'excitation de la couche active 2, configurés pour :

    faire transiter des électrons vers l'état excité, puis se relaxant vers le deuxième état de spin $S_2$ par l'intermédiaire de l'état métastable MS, de sorte que la couche active 2 peut émettre des photons faisant transiter des électrons du deuxième état de spin $S_2$ vers le premier état de spin $S_1$ ; ou
    faire transiter des électrons du deuxième état de spin $S_2$ vers l'état excité de sorte que la couche active 2 peut détecter des photons faisant transiter des électrons du premier état de spin $S_1$ vers le deuxième état de spin $S_2$ par absorption.

En d'autres termes, les moyens d'excitation de la couche active 2 sont configurés pour :

> faire transiter des électrons vers l'état excité, puis les électrons se relaxant vers le deuxième état de spin $S_2$ par l'intermédiaire de l'état métastable MS, de sorte que la couche active 2 émet des photons faisant transiter des électrons du deuxième état de spin $S_2$ vers le premier état de spin $S_1$ ; ou
> faire transiter des électrons du deuxième état de spin $S_2$ vers l'état excité de sorte que la couche active 2 détecte des photons faisant transiter des électrons du premier état de spin $S_1$ vers le deuxième état de spin $S_2$ par absorption.

L'expression « peut émettre des photons » s'entend comme une capacité (et non comme une possibilité éventuelle) lorsque les moyens d'excitation sont actionnés, c'est-à-dire lorsque le dispositif optoélectronique est en fonctionnement. De même, l'expression « peut détecter des photons » s'entend comme une capacité (et non comme une possibilité éventuelle) lorsque les moyens d'excitation sont actionnés, c'est-à-dire lorsque le dispositif optoélectronique est en fonctionnement.
Autrement dit, les moyens d'excitation de la couche active 2 sont configurés pour :

> faire transiter des électrons vers l'état excité, puis les électrons se relaxant vers le deuxième état de spin $S_2$ par l'intermédiaire de l'état métastable MS, de sorte que la couche active 2 est destinée à émettre des photons faisant transiter des électrons du deuxième état de spin $S_2$ vers le premier état de spin $S_1$ ; ou
> faire transiter des électrons du deuxième état de spin $S_2$ vers l'état excité de sorte que la couche active 2 est destinée à détecter des photons faisant transiter des électrons du premier état de spin $S_1$ vers le deuxième état de spin $S_2$ par absorption.

### Substrat

Le substrat 1 est avantageusement réalisé dans un matériau choisi parmi le silicium Si, le quartz $SiO_2$, le saphir $Al_2O_3$.

### Couche active

La couche active 2 présente des première et seconde surfaces 20, 21 opposées.
Le matériau de la couche active 2 possède avantageusement une bande d'énergie interdite Eg supérieure à 1,5 eV, de préférence supérieure à 2 eV. Le matériau de la couche active 2 comporte avantageusement au moins un composant choisi parmi le nitrure d'aluminium AlN, le nitrure de gallium GaN, l'arséniure de gallium GaAs, le phosphure de gallium GaP, le nitrure de bore BN, l'oxyde de zinc ZnO, le sulfure de zinc ZnS, le tellurure de magnésium MgTe, le séléniure de magnésium MgSe, le nitrure de silicium $Si_3N_4$, le carbure de silicium SiC, le dioxyde de silicium $SiO_2$, l'alumine $Al_2O_3$, le dioxyde de germanium $GeO_2$, un cristal organique, le diamant C.
Les défauts comportent avantageusement au moins un élément choisi parmi une lacune et une impureté (dopant). Autrement dit, les défauts peuvent comporter des lacunes et/ou des impuretés. A titre d'exemples non limitatifs, les lacunes peuvent être :

- des centres azote-lacune lorsque le matériau de la couche active 2 est en diamant ;
- des centres silicium-lacune lorsque le matériau de la couche active 2 est en carbure de silicium.

Le nombre de défauts peut être augmenté durant la formation des défauts au sein du matériau de la couche active 2 par différentes techniques :

> (i) ajout de défauts (impuretés) in situ ;
> (ii) modification des paramètres de croissance, tels que la température, la pression, le flux de précurseur dopant ;
> (iii) irradiation de particules (neutrons, électrons ou protons) selon une fluence pouvant atteindre $10^{20}$ cm$^{-2}$, une énergie comprise entre 1 eV et 100 MeV et une durée d'exposition comprise entre 1 seconde et 24 heures ;
> (iv) implantation d'ions (e.g. C, Si, N, Al, P, Ce, H) selon une dose pouvant atteindre $10^{20}$ cm$^{-2}$, une énergie comprise entre 1 eV et 100 MeV, et une durée d'exposition comprise entre 1 seconde et 24 heures ;
> (v) irradiation laser (e.g. UV, IR) selon une fluence comprise entre 1 J.cm$^2$ et 100 J.cm$^{-2}$.

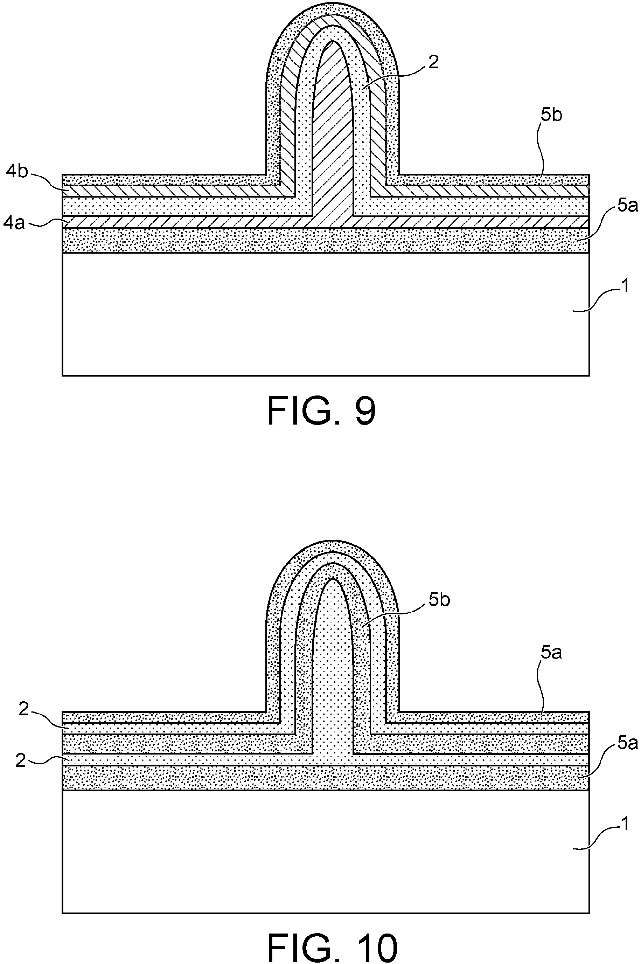

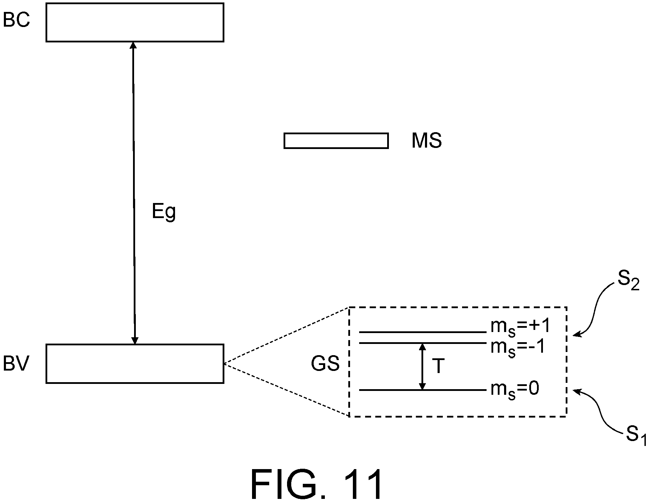

Un recuit thermique peut être nécessaire pour activer électriquement les défauts de type dopants, c'est-à-dire provoquer la migration des dopants en sites substitutionnels dans lesquels ils seront susceptibles d'engendrer des porteurs.
Comme illustré à la figure 11, la fréquence de la transition T entre les premier et deuxième états de spin $S_1$, $S_2$ de l'état fondamental GS peut être comprise entre 10 MHz et 1000 GHz, ou entre 30 MHz et 300 GHz. A titre d'exemple non limitatif, lorsque le matériau de la couche active 2 est en carbure de silicium, les défauts peuvent être des centres silicium-lacune avec une densité volumique de l'ordre de $10^{18}$ cm$^{-3}$, la transition T entre les premier et deuxième états de spin $S_1$, $S_2$ de l'état fondamental GS étant de l'ordre de 127 MHz $(0,53.10^{-6}$ eV$)$.
Comme illustré à la figure 9 et à la figure 10, la couche active 2 peut comporter des nanofilaments. La formation des nanofilaments est exécutée par des techniques connues de l'homme du métier, par exemple par une méthode vapeur-liquide-solide (VLS), une méthode solide-liquide-solide (SLS), un dépôt électro-chimique etc. A titre d'exemple non limitatif, lorsque le matériau de la couche active 2 est en nitrure de gallium, les gaz précurseurs peuvent être le triméthylgallium (TMG), de formule $Ga(CH_3)_3$ et l'ammoniac $NH_3$.

***Moyens d'excitation de la couche active en émission***

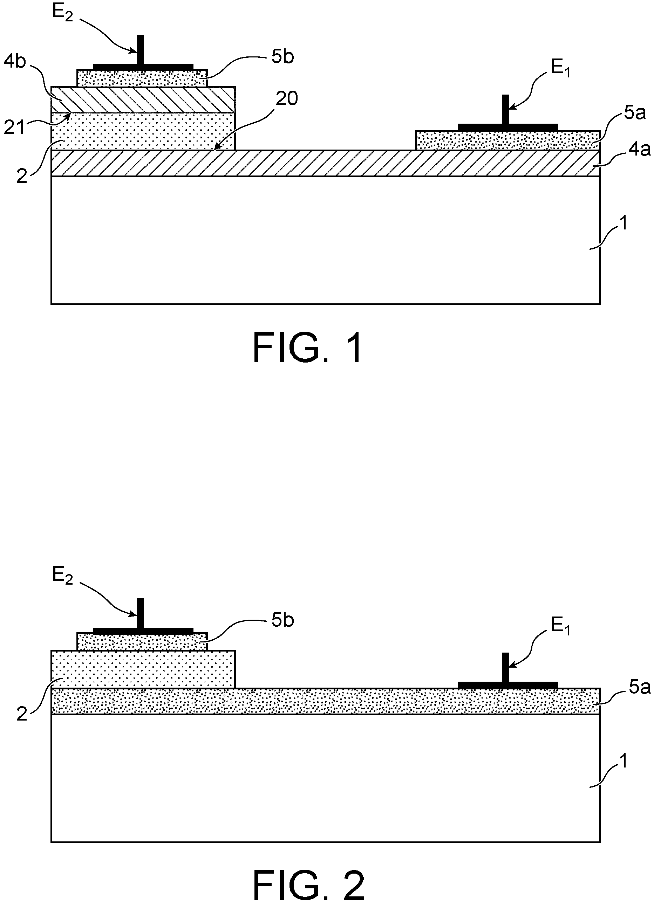

Selon un premier mode de réalisation illustré aux figures 1 à 5, les moyens d'excitation de la couche active 2 comportent :

- des première et deuxième électrodes $F_1$, $E_2$, électriquement connectées à la couche active 2 ;
- des moyens d'excitation électrique, agencés pour appliquer une tension de polarisation entre les première et deuxième électrodes $E_1$, $E_2$, les moyens d'excitation électrique étant configurés pour faire transiter des électrons vers l'état excité, puis se relaxant vers le deuxième état de spin $S_2$ par l'intermédiaire de l'état métastable MS, lorsque la tension de polarisation est positive.

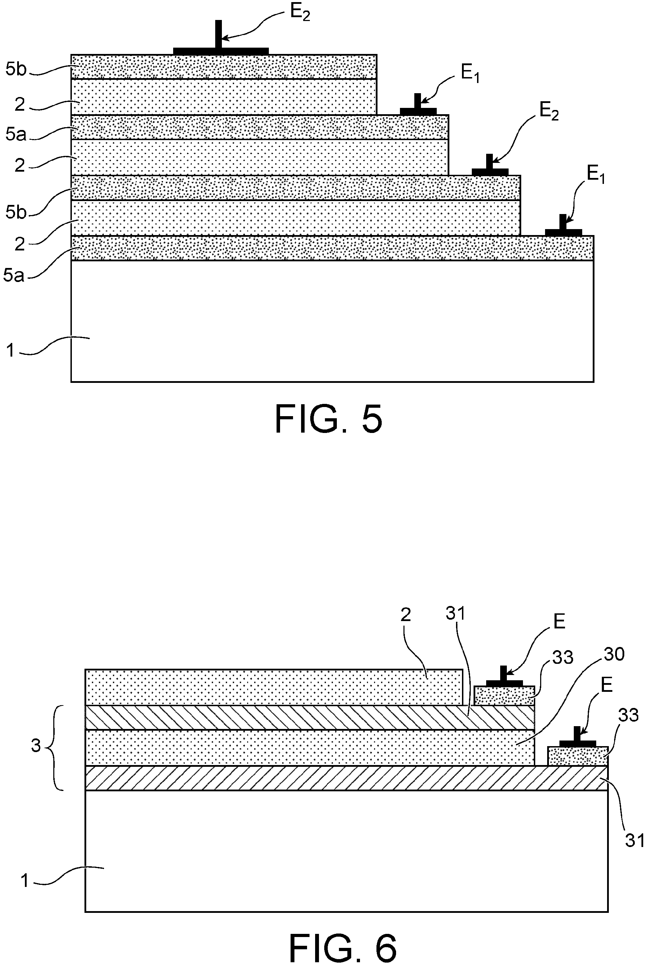

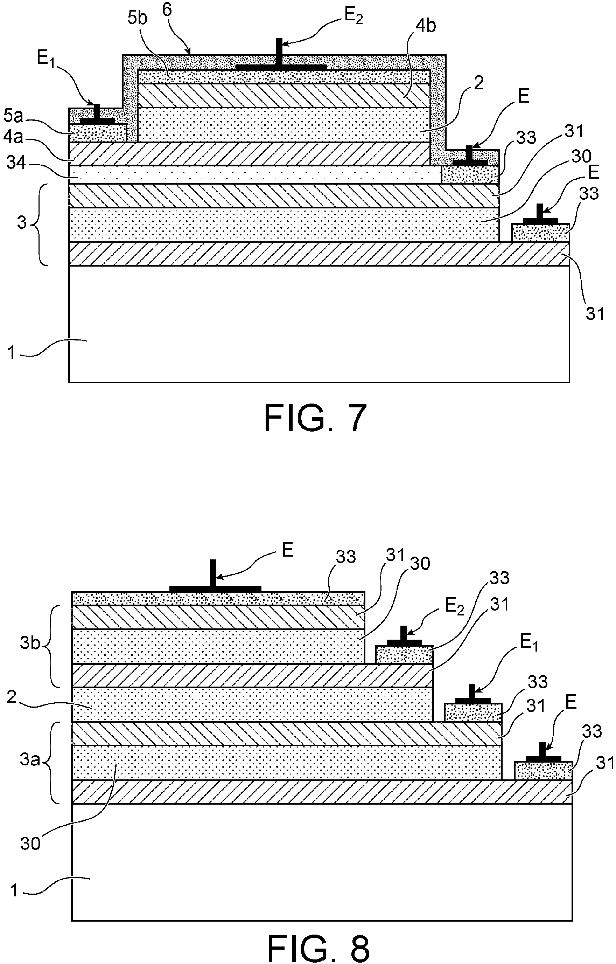

Selon un deuxième mode de réalisation illustré aux figures 6 et 8, les moyens d'excitation de la couche active 2 comportent des moyens d'excitation optique, configurés pour faire transiter des électrons vers l'état excité, puis se relaxant vers le deuxième état de spin Sz par l'intermédiaire de l'état métastable MS.

Selon un troisième mode de réalisation illustré à la figure 7, les moyens d'excitation de la couche active 2 comportent :

- des première et deuxième électrodes $E_1$, $E_2$, électriquement connectées à la couche active 2 ;
- des moyens d'excitation électrique, agencés pour appliquer une tension de polarisation entre les première et deuxième électrodes $E_1$, $E_2$, les moyens d'excitation électrique étant configurés pour faire transiter des électrons vers l'état excité, puis se relaxant vers le deuxième état de spin $S_2$ par l'intermédiaire de l'état métastable MS, lorsque la tension de polarisation est positive ;
- des moyens d'excitation optique, configurés pour faire transiter des électrons vers l'état excité, puis se relaxant vers le deuxième état de spin $S_2$ par l'intermédiaire de l'état métastable MS, notamment lorsque la tension de polarisation est positive.

Il est à noter que la transition des électrons vers l'état excité opérée par les moyens d'excitation optique ne nécessite pas, en tant que telle, une polarisation électrique des électrodes $E_1$, $E_2$ mais cette transition s'opère en combinaison avec les moyens d'excitation électrique lorsque la tension de polarisation est positive.

La couche active 2 peut alors émettre des photons faisant transiter des électrons du deuxième état de spin $S_2$ vers le premier état de spin $S_1$. L'intensité de l'émission des photons, notée I, peut s'écrire :

$$I \propto V\,N\,\rho$$

où :

- « V » est le volume de la couche active 2,
- « N » est le nombre de défauts par unité de volume,
- « $\rho$ » est l'inversion de population (i.e. la différence entre le nombre d'atomes présents dans l'état excité et le nombre d'atomes présents dans l'état fondamental).

Le dispositif comporte avantageusement un système de refroidissement cryogénique permettant de diminuer le bruit et d'améliorer la qualité du signal.

Le transit des électrons vers l'état excité, puis se relaxant vers le deuxième état de spin $S_2$ par l'intermédiaire de l'état métastable MS, peut s'effectuer à une température cryogénique (de l'ordre de quelques kelvins) ou à une température ambiante (de l'ordre de 300 K).

Les première et deuxième $E_1$, $E_2$, et tout ou partie des moyens d'excitation de la couche active 2 peuvent également être intégrés de manière monolithique avec le substrat 1 afin de former un circuit intégré. En particulier, les moyens d'excitation optique de la couche active 2 sont avantageusement intégrés de manière monolithique avec le substrat 1 afin de former un circuit intégré. Autrement dit, les moyens d'excitation optique sont disposés sur le même substrat 1 que la couche active 2.

***Moyens d'excitation de la couche active en détection***

Selon un mode de réalisation illustré à la figure 7, les moyens d'excitation de la couche active 2 comportent :

- des première et deuxième électrodes $E_1$, $E_2$, électriquement connectées à la couche active 2 ;
- des moyens d'excitation électrique, agencés pour appliquer une tension de polarisation entre les première et deuxième électrodes $E_1$, $E_2$, les moyens d'excitation électrique étant configurés pour faire transiter des électrons du deuxième état de spin $S_2$ vers l'état excité lorsque la tension de polarisation est négative ;
- des moyens d'excitation optique, configurés pour faire transiter des électrons du deuxième état de spin $S_2$ vers l'état excité, notamment lorsque la tension de polarisation est négative.

Il est à noter que la transition des électrons du deuxième état de spin $S_2$ vers l'état excité opérée par les moyens d'excitation optique ne nécessite pas, en tant que telle, une polarisation électrique des électrodes $E_1$, $E_2$ mais cette transition s'opère en combinaison avec les moyens d'excitation électrique lorsque la tension de polarisation est négative.

Le dispositif comporte avantageusement un système de refroidissement cryogénique permettant de diminuer le bruit et d'améliorer la qualité du signal.

Le transit des électrons du deuxième état de spin $S_2$ vers l'état excité peut s'effectuer à une température cryogénique (de l'ordre de quelques kelvins) ou à une température ambiante (de l'ordre de 300 K).

Les première et deuxième $E_1$, $E_2$, et tout ou partie des moyens d'excitation de la couche active 2 peuvent également être intégrés de manière monolithique avec le substrat 1 afin de former un circuit intégré. En particulier, les moyens d'excitation optique de la couche active 2 sont avantageusement intégrés de manière monolithique avec le substrat 1 afin de former un circuit intégré. Autrement dit, les moyens d'excitation optique sont disposés sur le même substrat 1 que la couche active 2.

### *Moyens d'excitation électrique (pompage électrique)*

A titre d'exemple non limitatif, les moyens d'excitation électrique peuvent comporter un circuit d'alimentation électrique, formé sur le substrat 1. Le circuit d'alimentation électrique et le dispositif peuvent être intégrés de manière monolithique sur le substrat 1.

### *Moyens d'excitation optique (pompage optique)*

Comme illustré aux figures 6 à 8, les moyens d'excitation optique comportent avantageusement au moins une diode électroluminescente 3 formée sur le substrat 1. Chaque diode électroluminescente 3 peut comporter une zone intrinsèque 30 et des zones dopées 31 s'étendant de part et d'autre de la zone intrinsèque 30 de manière à former une diode de type p-i-n. Les zones dopées 31 peuvent être reliées à des électrodes $E$, $E_1$, $E_2$ via des zones électriquement conductrices 33, de préférence réalisées dans un oxyde conducteur. Comme illustré à la figure 7, les moyens d'excitation optique comportent avantageusement une couche diélectrique 34 transparente (à la longueur d'onde du rayonnement émis par la ou les diodes électroluminescentes 3), agencée pour isoler électriquement la diode électroluminescente 3 de la couche active 2. Comme illustré à la figure 8, les moyens d'excitation optique peuvent comporter des première et deuxième diodes électroluminescentes 3a, 3b s'étendant de part et d'autre de la couche active 2. A titre d'exemple non limitatif, les moyens d'excitation optique peuvent être configurés pour émettre un rayonnement possédant une quantité d'énergie de 1,397 eV lorsque le matériau de la couche active 2 est en carbure de silicium.

Le dispositif peut comporter un résonateur optique à l'intérieur duquel s'étend la couche active 2, le résonateur optique étant conçu pour coopérer avec les moyens d'excitation optique de sorte que les moyens d'excitation optique font :

- transiter des électrons vers l'état excité, puis se relaxant vers le deuxième état de spin $S_2$ par l'intermédiaire de l'état métastable MS ; ou
- transiter des électrons du deuxième état de spin $S_2$ vers l'état excité.

Le résonateur optique permet de confiner les ondes émises par la ou les diodes électroluminescentes 3 et de perpétuer le phénomène d'émission stimulée. Le résonateur optique peut être un résonateur diélectrique (par exemple réalisé en saphir) ou une cavité optique formée par des parois métalliques réfléchissantes (par exemple réalisées en cuivre). Le résonateur optique peut être disposé sur le même substrat 1 que la couche active 2. En d'autres termes, le résonateur optique est avantageusement intégré de manière monolithique avec le substrat 1 afin de former un circuit intégré.

### *Différentes Architectures*

Le dispositif peut comporter :

- une première couche dopée 4a, d'un premier type de conductivité, s'étendant en contact de la première surface 20 de la couche active 2 ;
- une seconde couche dopée 4b, d'un second type de conductivité opposé au premier type de conductivité, s'étendant en contact de la seconde surface 21 de la couche active 2.

Le dispositif peut comporter :

- des première et deuxième électrodes $E_1$, $E_2$, électriquement connectées à la couche active ;
- une première couche électriquement conductrice 5a, de préférence réalisée dans un oxyde conducteur, s'étendant entre la première électrode $E_1$ et la couche active 2 ;
- une deuxième couche électriquement conductrice 5b, de préférence réalisée dans un oxyde conducteur, s'étendant entre la couche active 2 et la deuxième électrode $E_2$.

La première couche électriquement conductrice 5a peut s'étendre entre la première électrode $E_1$ et la première couche dopée 4a. La deuxième couche électriquement conductrice 5b peut s'étendre entre la seconde couche dopée 4b et la deuxième électrode $E_2$. A titre d'exemples non limitatifs, les première et deuxième couches électriquement conductrices 5a, 5b peuvent être des oxydes transparents conducteurs, tels que $In_2O_3$:H, InSnO, InZnO, $In_2O_3$:Zr, ZnO:Al, ZnSnO, ZnO:B, ZnO:Ga. De manière alternative, comme illustré aux figures 9 et 10, les première et deuxième couches électriquement conductrices 5a, 5b peuvent former un réseau de nanofils métalliques (Au, Ag, Cu etc.).

Comme illustré à la figure 1, la première couche dopée 4a peut s'étendre à la surface du substrat 1, et peut être formée par un dépôt de type pleine plaque. La première couche électriquement conductrice 5a est formée sur la première couche dopée 4a. La couche active 2, la seconde couche dopée 4b et la deuxième couche électriquement conductrice 5b sont formées successivement sur la première couche dopée 4a, à distance de la première couche électriquement conductrice 5a.

Comme illustré à la figure 9, les première et seconde couches dopées 4a, 4b peuvent être réalisées sous la forme de filaments. Lorsque les filaments des première et seconde couches dopées 4a, 4b sont en nitrure de gallium, en cas de dopage de type p, les précurseurs peuvent être le magnésocène de formule $Mg(C_5H_5)_2$ ou le bis(methylcyclopentadienyl)magnesium de formule $(CH_3C_5H_4)_2Mg$. En cas de dopage de type n, les précurseurs peuvent être le silane $SiH_4$ ou le germane $GeH_4$.

Comme illustré à la figure 2, les première et seconde couches dopées 4a, 4b sont facultatives. La première couche électriquement conductrice 5a peut s'étendre à la surface du substrat 1, et peut être formée par un dépôt de type pleine plaque. La couche active 2 et la deuxième couche électriquement conductrice 5b peuvent être formées successivement sur la première couche électriquement conductrice 5a.

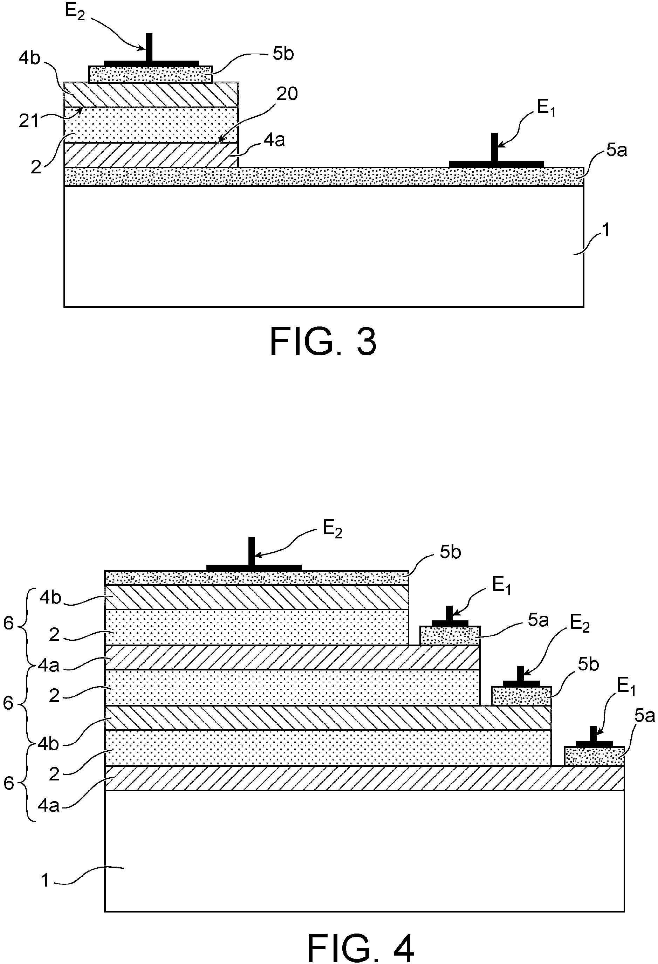

Comme illustré à la figure 3, la première couche électriquement conductrice 5a peut s'étendre à la surface du substrat 1, et peut être formée par un dépôt de type pleine plaque. La première couche dopée 4a, la couche active 2, la seconde couche dopée 4b, et la deuxième couche électriquement conductrice 5b peuvent être formées successivement sur la première couche électriquement conductrice 5a.

Comme illustré à la figure 4, le dispositif peut comporter :

- un ensemble de couches actives 2 ;
- une succession de diodes de type p-i-n 6 formée sur le substrat 2, chaque diode de type p-i-n 6 possédant une zone intrinsèque formée par une couche active 2 de l'ensemble.

Chaque couche active 2 est électriquement connectée à un couple d'électrodes $E_1$, $E_2$.

Comme illustré à la figure 5, le dispositif peut comporter un ensemble de couches actives 2, chaque couche active 2 étant en contact avec des première et deuxième couches électriquement conductrices 5a, 5b. Chacune des première et deuxième couches électriquement conductrices sont électriquement connectées à un couple d'électrodes $E_1$, $E_2$.

Le dispositif peut comporter des moyens d'application d'un champ magnétique aux défauts, dans lequel la transition T entre les premier et deuxième états de spin $S_1$, $S_2$ est définie en présence du champ magnétique. A cet effet, les moyens d'application du champ magnétique peuvent comporter une couche ferromagnétique formée sur le substrat 1. La couche ferromagnétique est avantageusement formée à proximité de la couche active 2.

Selon une alternative, la transition T entre les premier et deuxième états de spin $S_1$, $S_2$ est définie en l'absence d'un champ magnétique (ZFS, acronyme pour « *Zero Field Splitting* » en langue anglaise).

Comme illustré à la figure 7, le dispositif comporte avantageusement une couche d'encapsulation 6, agencée pour encapsuler la couche active 2. Une couche de filtrage est avantageusement formée au-dessous de la couche d'encapsulation 6, la couche de filtrage étant conçue pour filtrer des ondes externes possédant une longueur d'onde inférieure ou égale à la longueur d'onde de la ou des diodes électroluminescentes 3. Une telle couche de filtrage permet d'éviter une excitation optique de la couche active 2 provenant du milieu extérieur. Le dispositif peut comporter un résonateur optique comprenant des première et seconde surfaces réfléchissantes (à la longueur d'onde du rayonnement émis par la ou les diodes électroluminescentes 3). La première surface réfléchissante du résonateur optique peut être formée entre le substrat 1 et la diode électroluminescente 3. La seconde surface réfléchissante du résonateur optique peut être formée sous la couche de filtrage.

L'invention ne se limite pas aux modes de réalisation exposés. L'homme du métier est mis à même de considérer leurs combinaisons techniquement opérantes, et de leur substituer des équivalents.

**Revendications**

1. Dispositif optoélectronique, comportant :

   - un substrat (1),
   - au moins une couche active (2), formée sur le substrat (1), et réalisée dans un matériau possédant une bande de valence (BV) et une bande de conduction (BC) séparées par une bande d'énergie interdite (Eg) ;
   - des défauts, présents dans le matériau, et possédant une structure énergétique définissant :

     un état fondamental (GS) dans la bande de valence (BV), comprenant des premier et deuxième états de spin (Si, $S_2$), la transition (T) du deuxième état de spin ($S_2$) vers le premier état de spin ($S_1$) étant destinée à être radiative,
     un état métastable (MS) dans la bande d'énergie interdite (Eg),
     un état excité dans la bande de conduction (BC) ;

   - des moyens d'excitation de la couche active (2), configurés pour :

     faire transiter des électrons vers l'état excité, puis se relaxant vers le deuxième état

de spin ($S_2$) par l'intermédiaire de l'état métastable (MS), de sorte que la couche active (2) peut émettre des photons faisant transiter des électrons du deuxième état de spin ($S_2$) vers le premier état de spin ($S_1$) ; ou faire transiter des électrons du deuxième état de spin ($S_2$) vers l'état excité de sorte que la couche active (2) peut détecter des photons faisant transiter des électrons du premier état de spin ($S_1$) vers le deuxième état de spin ($S_2$) par absorption.

2. Dispositif selon la revendication 1, dans lequel les moyens d'excitation de la couche active (2) comportent :

   - des première et deuxième électrodes ($E_1$, $E_2$), électriquement connectées à la couche active (2) ;
   - des moyens d'excitation électrique, agencés pour appliquer une tension de polarisation entre les première et deuxième électrodes ($E_1$, $E_2$), les moyens d'excitation électrique étant configurés pour faire transiter des électrons vers l'état excité, puis se relaxant vers le deuxième état de spin ($S_2$) par l'intermédiaire de l'état métastable (MS), lorsque la tension de polarisation est positive.

3. Dispositif selon la revendication 1, dans lequel les moyens d'excitation de la couche active (2) comportent des moyens d'excitation optique, configurés pour faire transiter des électrons vers l'état excité, puis se relaxant vers le deuxième état de spin ($S_2$) par l'intermédiaire de l'état métastable (MS).

4. Dispositif selon la revendication 3, dans lequel les moyens d'excitation optique sont situés sur le même substrat (1) que la couche active (2).

5. Dispositif selon la revendication 1, dans lequel les moyens d'excitation de la couche active (2) comportent :

   - des première et deuxième électrodes ($E_1$, $E_2$), électriquement connectées à la couche active (2) ;
   - des moyens d'excitation électrique, agencés pour appliquer une tension de polarisation entre les première et deuxième électrodes ($E_1$, $E_2$), les moyens d'excitation électrique étant configurés pour faire transiter des électrons vers l'état excité, puis se relaxant vers le deuxième état de spin ($S_2$) par l'intermédiaire de l'état métastable (MS), lorsque la tension de polarisation est positive ;
   - des moyens d'excitation optique, configurés pour faire transiter des électrons vers l'état excité, puis se relaxant vers le deuxième état de spin ($S_2$) par l'intermédiaire de l'état métastable (MS).

6. Dispositif selon la revendication 1, dans lequel les moyens d'excitation de la couche active (2) comportent :

   - des première et deuxième électrodes ($E_1$, $E_2$), électriquement connectées à la couche active (2) ;
   - des moyens d'excitation électrique, agencés pour appliquer une tension de polarisation entre les première et deuxième électrodes ($E_1$, $E_2$), les moyens d'excitation électrique étant configurés pour faire transiter des électrons du deuxième état de spin ($S_2$) vers l'état excité lorsque la tension de polarisation est négative ;
   - des moyens d'excitation optique, configurés pour faire transiter des électrons du deuxième état de spin ($S_2$) vers l'état excité.

7. Dispositif selon l'une des revendications 3 à 6, dans lequel les moyens d'excitation optique comportent au moins une diode électroluminescente (3, 3a, 3b) formée sur le substrat (1).

8. Dispositif selon la revendication 7, dans lequel les moyens d'excitation optique comportent des première et deuxième diodes électroluminescentes (3a, 3b) s'étendant de part et d'autre de la couche active (2).

9. Dispositif selon l'une des revendications 3 à 8, comportant un résonateur optique à l'intérieur duquel s'étend la couche active (2), le résonateur optique étant conçu pour coopérer avec les moyens d'excitation optique de sorte que les moyens d'excitation optique font :

   - transiter des électrons vers l'état excité, puis se relaxant vers le deuxième état de spin ($S_2$) par l'intermédiaire de l'état métastable (MS) ; ou
   - transiter des électrons du deuxième état de spin ($S_2$) vers l'état excité.

10. Dispositif selon l'une des revendications 1 à 9, dans lequel la couche active (2) présente des première et seconde surfaces (20, 21) opposées ; le dispositif comportant :

    - une première couche dopée (4a), d'un premier type de conductivité, s'étendant en contact de la première surface (20) de la couche active (2) ;
    - une seconde couche dopée (4b), d'un second type de conductivité opposé au premier type de conductivité, s'étendant en contact de la seconde surface (21) de la couche active (2).

**11.** Dispositif selon l'une des revendications 1 à 10, comportant :

- des première et deuxième électrodes ($E_1$, $E_2$), électriquement connectées à la couche active (2) ;
- une première couche électriquement conductrice (5a), de préférence réalisée dans un oxyde conducteur, s'étendant entre la première électrode ($E_1$) et la couche active (2) ;
- une deuxième couche électriquement conductrice (5b), de préférence réalisée dans un oxyde conducteur, s'étendant entre la couche active (2) et la deuxième électrode ($E_2$).

**12.** Dispositif selon la revendication 11 en combinaison avec la revendication 10, dans lequel :

- la première couche électriquement conductrice (5a) s'étend entre la première électrode ($E_1$) et la première couche dopée (4a) ;
- la deuxième couche électriquement conductrice (5b) s'étend entre la seconde couche dopée (4b) et la deuxième électrode ($E_2$).

**13.** Dispositif selon l'une des revendications 1 à 12, comportant :

- un ensemble de couches actives (2) ;
- une succession de diodes de type p-i-n (6) formée sur le substrat (1), chaque diode de type p-i-n (6) possédant une zone intrinsèque formée par une couche active (2) de l'ensemble.

**14.** Dispositif selon l'une des revendications 1 à 13, comportant des moyens d'application d'un champ magnétique aux défauts, dans lequel la transition (T) entre les premier et deuxième états de spin (Si, $S_2$) est définie en présence du champ magnétique.

**15.** Dispositif selon l'une des revendications 1 à 14, dans lequel le matériau de la couche active (2) possède une bande d'énergie interdite supérieure à 1,5 eV, de préférence supérieure à 2 eV.

FIG. 1

FIG. 2

E₂

4b

21

2

5b

20

4a

E₁

5a

1

## FIG. 3

E₂

4b

6

2

4a

6

2

4b

6

2

4a

1

5b

E₁

5a

E₂

5b

E₁

5a

## FIG. 4

E₂

5b

2

5a

2

5b

2

5a

E₁

E₂

E₁

1

FIG. 5

2  31

E

33  30

E

33

3

31

1

FIG. 6

FIG. 7

FIG. 8

FIG. 9

FIG. 10

FIG. 11

Europäisches
Patentamt

European
Patent Office

Office européen
des brevets

# RAPPORT DE RECHERCHE EUROPEENNE

Numéro de la demande

**EP 23 18 4094**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2017/343695 A1 (STETSON JOHN B [US] ET AL) 30 novembre 2017 (2017-11-30) <br> * alinéa [0491] – alinéa [0493]; figures 3a, 114 * <br> * alinéa [0913] – alinéa [0915] * <br> ----- | 1,3,7,15 | INV. <br> H10N70/00 <br> H01L33/00 <br> H01L25/07 |
| X | US 2020/052101 A1 (PETTA JASON [US] ET AL) 13 février 2020 (2020-02-13) <br> * alinéas [0004], [0005], [0109]; figure 2c * <br> ----- | 1,14 | |
| X | BOURGEOIS EMILIE ET AL: "Photoelectric Detection and Quantum Readout of Nitrogen-Vacancy Center Spin States in Diamond", <br> ADVANCED OPTICAL MATERIALS <br> , <br> vol. 8, no. 12 <br> 1 juin 2020 (2020-06-01), page 1902132, XP093033212, <br> DE <br> ISSN: 2195-1071, DOI: <br> 10.1002/adom.201902132 <br> Extrait de l'Internet: <br> URL:https://onlinelibrary.wiley.com/doi/full-xml/10.1002/adom.201902132 <br> * alinéa [02.1]; figure 1 * <br> ----- | 1 | |

**DOMAINES TECHNIQUES RECHERCHES (IPC)**

H10N
H01L

Le présent rapport a été établi pour toutes les revendications

| Lieu de la recherche | Date d'achèvement de la recherche | Examinateur |
|---|---|---|
| Munich | 7 décembre 2023 | Angermeier, Detlef |

**ANNEXE AU RAPPORT DE RECHERCHE EUROPEENNE
RELATIF A LA DEMANDE DE BREVET EUROPEEN NO.**

EP 23 18 4094

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

07-12-2023

| Document brevet cité au rapport de recherche | Date de publication | Membre(s) de la famille de brevet(s) | Date de publication |
|---|---|---|---|
| US 2017343695 A1 | 30-11-2017 | AUCUN | |
| US 2020052101 A1 | 13-02-2020 | US 2020052101 A1 | 13-02-2020 |
| | | US 2021367065 A1 | 25-11-2021 |

EPO FORM P0460

Pour tout renseignement concernant cette annexe : voir Journal Officiel de l'Office européen des brevets, No.12/82